Europäisches Patentamt

European Patent Office

Office européen des brevets

(11) Publication number: **0 286 135**
**A2**

# (12) EUROPEAN PATENT APPLICATION

(21) Application number: 88105663.4

(22) Date of filing: 08.04.88

(51) Int. Cl.⁴: **H01L 39/24**

(30) Priority: 10.04.87 JP 89163/87
14.04.87 JP 91117/87
20.05.87 JP 123333/87
20.05.87 JP 123334/87
20.05.87 JP 123335/87
23.05.87 JP 126172/87

(43) Date of publication of application:
12.10.88 Bulletin 88/41

(84) Designated Contracting States:
DE FR GB

(71) Applicant: SUMITOMO ELECTRIC INDUSTRIES, LIMITED
15, Kitahama 5-chome Higashi-ku
Osaka-shi Osaka-fu(JP)

(72) Inventor: Okuda, Shigeru c/o Osaka Works
Sumitomo Electric Ind. Ltd. 1-3 Shimaya 1-chome
Konohana-ku Osaka-shi Osaka-fu(JP)

(74) Representative: Hansen, Bernd, Dr.rer.nat. et al
Hoffmann, Eitle & Partner Patentanwälte
Arabellastrasse 4
D-8000 München 81(DE)

(54) Method for producing ceramic oxide superconductor.

(57) A method for producing, on a substrate, a superconductor having a composition of the formula:

$$M^1_x M^2_y M^3_z \quad (I)$$

wherein $M^1$ is at least one element selected from the elements of the Ia, IIa and IIIa groups, $M^2$ is at least one element selected from the group consisting of elements of Ib, IIb and IIIb groups and $M^3$ is at least one element selected from the group consisting of oxygen, nitrogen, fluorine, carbon and sulfur, which comprises flame spraying a raw material selected from the group consisting of complex ceramics comprising the elements $M^1$, $M^2$ and $M^3$ and a mixture of the elements $M^1$, $M^2$ and $M^3$ or compounds each comprising at least one of the elements $M^1$, $M^2$ and $M^3$ and optionally heating a complex of the superconductor and the substrate.

## METHOD FOR PRODUCING CERAMIC OXIDE SUPERCONDUCTOR

### BACKGROUND OF THE INVENTION

#### Field of the Invention

The present invention relates to a method for producing a ceramic oxide superconductor. More particularly, it relates to a method for producing a ceramic oxide superconductor by flame spraying on a substrate to form a composite material comprising a substrate and said ceramic superconductor.

#### Description of the Related Art

Recently, ceramic oxide superconductors with a high critical temperature Tc have attracted much attention. As such high Tc ceramic superconductor, those having a perovskite type crystal structure are known and have Tc not lower than 30K.

Generally, the ceramic superconductor is produced by molding powdery compounds, such as oxides and carbonates of elements which constitute the superconductor in a desired shape followed by sintering.

Since the molding for pressing the powder is essential in the conventional method, the superconductor cannot be shaped in a desired shape in some cases. For example, the powdery raw materials cannot be shaped in an elongate form or in a thin wire form. Therefore, a superconductive wire or a thin wire for superconductor device cannot be produced by the conventional method.

### SUMMARY OF THE INVENTION

One object of the present invention is to provide a method for producing a superconductor composite material comprising a substrate and a superconductor layer formed thereon, which has an arbitrary shape such as a long wire and a thin wire.

Another object of the present invention is to provide a method for producing a superconductor on a substrate, in which the superconductor is hardly peeled from the substrate.

A further object of the present invention is to provide a method for producing a superconductor on a substrate in which an oxygen content in the superconductor is easily adjusted.

According to the present invention, there is provided a method for producing, on a substrate, a superconductor having a composition of the formula:

$$M^1_x M^2_y M^3_z \quad (I)$$

wherein $M^1$ is at least one element selected from the elements of the Ia, IIa and IIIa groups, $M^2$ is at least one element selected from the group consisting of elements of Ib, IIb and IIIb groups and $M^3$ is at least one element selected from the group consisting of oxygen, nitrogen, fluorine, carbon and sulfur, which comprises flame spraying a raw material selected from the group consisting of complex ceramics comprising the elements $M^1$, $M^2$ and $M^3$ and a mixture of the elements $M^1$, $M^2$ and $M^3$ or compounds each comprising at least one of the elements $M^1$, $M^2$ and $M^3$ and optionally heating a composite material of the superconductor and the substrate.

### BRIEF DESCRIPTION OF THE DRAWINGS

Fig. 1 shows a method for producing a superconductor composite material according to the present invention,

Fig. 2 shows a method for producing an elongate superconductor composite material according to the present invention, and

Fig. 3 is a cross section of a superconductor composite material produced in Example 3 or 4.

### DETAILED DESCRIPTION OF THE INVENTION

According to the method of the present invention, the complex ceramics comprising the elements $M^1$, $M^2$ and $M^3$ or the mixture of these elements or of the compounds of these elements is flame sprayed on the substrate. When a substrate of a desired shape such as a wire or a tape is used or when the raw material is flame sprayed in a desired pattern, a superconductor composite material having a desired shape can be produced.

When the ceramic superconductor itself is used as the complex ceramics, the produced superconductor has excellent superconductive properties without post-heating.

In a preferred embodiment, instead of flame spraying all the raw materials, the elements $M^1$ and $M^2$ or their compounds are flame sprayed on the substrate and then heated in an atmosphere containing the element $M^3$ or the compound comprising the element $M^3$. In this case, a concentration of the element $M^3$ in the heating atmosphere is preferably not smaller than 10 atomic %. In a modified embodiment, the flame spraying can be carried out in the presence of the element $M^3$ to incorporate it in the sprayed material, whereby the elements $M^1$

and $M^2$ more homogeneously and reliably react with the element $M^3$ during post-heating in the atmosphere containing the latter element.

The flame spraying can be carried out by any of conventional methods such as a thermospray process in which powdery raw materials are melt by oxygen-acetylene flame and injected and a plasma process in which powdery raw materials are supplied in high temperature high pressure plasma to melt them and melt materials are injected.

The flame spraying may be carried out under elevated, normal or reduced pressure in the presence or absence of the element $M^3$ in various atmosphere according to the kinds and composition of the elements contained in the raw materials and so on. Generally, when the spraying is carried out under the reduced pressure, the superconductor with high consistency and good quality can be produced.

The thickness of the superconductor formed on the substrate is not critical in the present invention and depends on the desired superconductive properties, proper ties of the substrate, kinds and composition of the elements constituting the superconductor and so on. Preferably, the thickness is from 10 μm to 3 mm.

As the raw material for the flame spraying, any of the complex ceramics comprising the elements $M^1$, $M^2$ and $M^3$ and the elements $M^1$, $M^2$ and $M^3$ themselves or their compounds can be used. Examples of the compounds of the elements include oxides, carbonates and fluorides. The complex ceramics as the raw material may be prepared by presintering the compounds comprising the elements $M^1$, $M^2$ and/or $M^3$.

As the atmosphere containing the element $M^3$, oxygen gas, nitrogen gas, fluorine gas, carbon dioxide gas, sulfrous acid gas and mixtures thereof are exemplified.

Examples of the Ia group elements are Li, Na, K, Rb, Cs and Fr, and examples of the Ib group elements are Cu, Ag and Au.

Examples of the IIa group elements are Be, Mg, Ca, Sr, Ba and Ra, and examples of the IIb group elements are Zn, Cd and the like.

Examples of the IIIa group elements are Sc, Y, lanthanoids (e.g. La, Ce, Pr, Nd, Pm, Sm, Eu, Gd, Tb, Dy, Ho, Er, Tm, Yb and Lu) and actinoids (e.g. Ac, Th, Pa and Cf), and examples of IIIb group elements are Al, Ga, In and Tl.

Among the superconductors, those comprising at least one element selected from the Ib group elements, at least one element selected from the IIa and IIIa group elements and lanthanoids and at least one element selected from the group consisting of oxygen, carbon and sulfur are preferred, since the superconductor comprising those elements has higher Tc. Among the Ib group elements, Cu and Ag are more preferred.

Particularly, the superconductor having much improved superconductive properties can be produced, when the superconductor contains, as the $M^1$ elements, at least two elements elected from the elements of the Ia, IIa and IIIa groups, for example, a combination of Y and Ba or La and Sr are used, or when the ceramic superconductor as such is flame sprayed.

The substrate is selected from wide variety of materials. Examples of the substrate are inorganic materials (e.g. glass, metals, ceramics, quartz, etc.) and organic materials (e.g. organic polymers. etc.).

The substrate may be of any shape. Not only a plate but also a wire, a tape, a sheet and a block can be used according to the end use of the superconductor composite material.

When the substrate is an elongate substrate such as the wire and the tape, it is unwound from a supply reel and then the raw material is continuously flame sprayed around the substrate or on a desired surface of the substrate. The produced elongate superconductor composite material is wound by a take-up reel. Thereby, the elongate superconductor composite material is continuously produced.

The substrate may be preheated to a temperature not lower than 500°C. By the preheating of the substrate, the superconductor having better superconductive properties can be produced.

If desired, the produced superconductor composite material may be heated at a high temperature, for example, not lower than 500°C, preferably not lower than 800°C, more preferably not lower than 940°C to improve the superconductive properties.

During such post-heating of the superconductor composite material, the ceramic superconductor may be peeled from the substrate due to the difference of coefficients of linear expansion between the superconductor and the substrate. Therefore, the substrate preferably has a coefficient of linear expansion of not larger than $15 \times 10^{-6}/°C$.

Examples of the materials having such coefficient of linear expansion are aluminum oxide ($Al_2O_3$), iron-42 % nickel alloy, silicon nitride ($Si_3N_4$), beryllium oxide (BeO), iron, platinum, tungsten and the like.

If the post-heated superconductor composite material is rapidly cooled, peeling of the superconductor from the substrate is enhanced by internal stress caused by shrinkage. Therefore, the post-heated superconductor is preferably cooled gradually. A cooling rate depends on various factors such as the kind of the substrate and the composition of the superconductor. Usually, the cooling rate is from 100 to 300°C per hour. To prevent the change of superconductor composition, the post-heated superconductor composite material is preferably cooled in an atmosphere containing the element $M^3$.

Generally, the flame spraying is carried out in the presence of oxygen, especially in the air. The content of oxygen in the flame spraying atmosphere is usually from 10 to 100 % by volume, preferably from 16 to 60 % by volume.

If the flame spraying is carried out in the presence of oxygen, the superconductor catches oxygen or reacts with oxygen and therefore an excess amount of oxygen is contained in the formed superconductor, which results in deviation of composition of the superconductor from the intended composition or decrease of the superconductive properties such as the critical temperature and the critical current density.

In such case, the superconductor composite material is post-heated in an oxygen-free atmosphere to eliminate excess oxygen from the superconductor so as to adjust the composition. The post-heating in the absence of oxygen can be carried out at substantially the same temperature as the above described post-heating. The "oxygen-free atmosphere" herein used is intended to mean an atmosphere containing substantially no oxygen and includes a reducing atmosphere such as a hydrogen atmosphere and a carbon monoxide atmosphere, an inert gas atmosphere such as nitrogen, helium and argon, and an atmosphere having reduced pressure of, for example, not higher than 10 Torr.

In another measure for preventing the excess oxygen in the formed superconductor, a content (z') of the element $M^3$ in the raw material is made smaller than the content (z) of the element $M^3$ in the formed superconductor. Thereby, it is made possible to control a supply amount of oxygen during flame spraying and in turn the content (z) of the element $M^3$ in the formed superconductor. More particularly, when a relationship between a set of the content z' of the element $M^3$ in the raw material, the oxygen content in the flame spraying atmosphere and the supply amount of oxygen with the content z of the element $M^3$ in the produced superconductor is established, the content z can be precisely controlled. The content z' of the element $M^3$ in the raw material may be suitably adjusted according to the oxygen content in the flame spraying atmosphere and other spraying conditions. Preferably, the contents z' and z satisfy the following equation:

$$0.1 < z'/z < 1.0$$

especially

$$0.2 < z'/z < 0.5.$$

The method for producing the superconductor on the substrate is illustrated by making reference to the accompanying drawings.

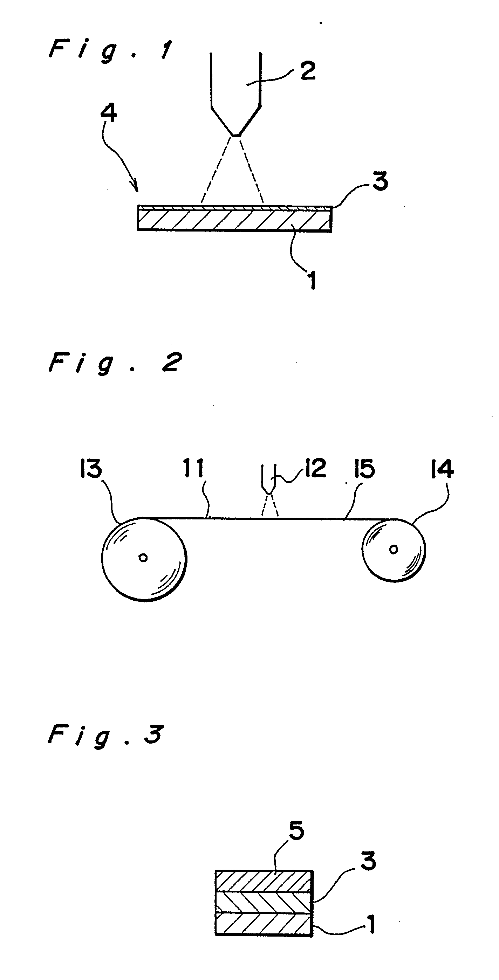

Fig. 1 schematically shows a method for flame spraying the raw material on the substrate 1 to form a superconductor layer 3 on the substrate.

The raw materials such as the complex ceramics, the elements or the compounds are sprayed from a spray nozzle 2 on a suitable surface area of the substrate. Thereby, the superconductor layer 3 is formed to produce a superconductor composite material 4.

Fig. 2 shows a method for forming a superconductor layer on an elongate substrate such as a wire and a tape. An elongate substrate 11 is unwound from a supply reel 13. Then, the raw materials are flame sprayed around or on a surface of the elongate substrate from a nozzle 12 to form a superconductor layer. A superconductor composite material 15 comprising the substrate 11 and the superconductor layer is wound on a take-up reel 14. If desired, the wound composite material is subjected to post-treatment such as post-heating.

## PREFERRED EMBODIMENTS OF THE INVENTION

The present invention will be explained further in detail by following Examples.

### Example 1

On a copper tape as a substrate, a ceramic superconductive material having a composition of $La_{1.6}Sr_{0.4}CuO_4$ was flame sprayed to continuously form a ceramic superconductor film having substantially the same composition and a thickness of 0.5 mm on one surface of the substrate.

The produced ceramic superconductor composite material was heated in an oxygen atmosphere at 900°C for 6 hours and thereby the superconductive properties were further stabilized.

The ceramic superconductor composite material had a critical temperature of 20K and no defect such as cracking.

### Example 2

On a copper tape as a substrate, a film of a material having a composition of $La_{1.6}Sr_{0.4}Cu$ and a thickness of 0.5 mm was continuously formed. Then, it was heated in the oxygen atmosphere at 900°C for 6 hours to form a ceramic superconductor film having a composition of $La_{1.6}Sr_{0.4}CuO_4$.

The ceramic superconductor composite material had a critical temperature of 20K and no defect such as cracking.

## Example 3

On a copper tape as a substrate, powder of La, Sr and Cu was flame sprayed in the oxygen atmosphere to continuously form a ceramic superconductor film 3 having a composition of $La_{1.6}Sr_{0.4}CuO_4$ on one surface the substrate as shown in Fig. 3.

On the superconductor film 3, copper 5 was flame sprayed to produce a ceramic superconductor composite material in which the superconductor film was sandwiched by the copper layers. The three layered ceramic superconductor composite material was heated in the oxygen atmosphere at 800°C for 6 hours, and thereby the superconductive properties were further stabilized.

The ceramic superconductor composite material had no defect such as cracking.

## Example 4

On a copper tape as a substrate, powder of $Y_2O_3$, $BaCO_3$ and CuO was plasmasprayed to continuously form a ceramic superconductor film 3 having a composition of $Y_{0.3}BaCu_{0.7}O_{z1}$ and a thickness of 0.3 mm on one surface of the substrate.

On the superconductor film 3, copper 5 was flame sprayed to a thickness of 0.1 mm to produce a ceramic superconductor composite material in which the superconductor film was sandwiched by the copper layers. The three layered ceramic superconductor composite material was heated in the oxygen atmosphere at 800°C. Thereby, the superconductor having a composition of $Y_{0.3}BaCu_{0.7}O_{z2}$ and improved properties was obtained.

The ceramic superconductor composite material had a critical temperature of 50K and no defect such as cracking.

## Example 5

A mixture of $Y_2O_3$ (1,129 g), $BaCO_3$ (5,300 g) and CuO (3,600 g) was heated at 900°C for 12 hours and then ground.

The ground mixture was plasma sprayed on a surface of a substrate made of aluminum oxide to form a ceramic superconductor film having a thickness of 100 $\mu$m on the substrate.

The produced ceramic superconductor composite material was heated in the air at 940°C for 6 hours and thereafter cooled at a cooling rate of 60°C/hr to form a superconductor film having a composition of $Y_1Ba_2Cu_3O_7$.

The ceramic superconductor composite material had a critical temperature of 87K and no defect such as cracking or peeling.

## Comparative Example

The powdery raw materials prepared in the same manner as in Example 5 were plasma sprayed on a substrate made of aluminum oxide to form a ceramic superconductor film having a thickness of 100 $\mu$m on the substrate.

The produced ceramic superconductor composite material was heated in the air at 400°C for 15 hours and thereafter cooled at the same cooling rate as in Example 5 to form a superconductor film having a composition of $Y_1Ba_2Cu_3O_7$.

The ceramic superconductor composite material had a critical temperature lower than that of Example 5.

## Example 6

A mixture of $Y_2O_3$ (1,129 g), $BaCO_3$ (5,300 g) and CuO (3,600 g) was heated at 900°C for 12 hours and then ground.

The ground mixture was plasma sprayed on a surface of a substrate made of aluminum oxide to form a ceramic superconductor film having a thickness of 100 $\mu$m on the substrate.

The produced ceramic superconductor composite material was heated at 940°C under reduced pressure of 1 Torr. for 6 hours and thereafter cooled at a cooling rate of 60°C/hr to form a superconductor film having a composition of $Y_1Ba_2Cu_3O_7$.

The ceramic superconductor composite material had a critical temperature of 83K and stable superconductive properties and no defect such as cracking or peeling.

## Example 7

A mixture of $Y_2O_3$ (1,129 g), $BaCO_3$ (5,263 g) and CuO (3,579 g) was heated at 900°C for 12 hours in a hydrogen atmosphere (reducing atmosphere) and then ground. The composition of the ground raw materials were $Y_1Ba_{2.6}Cu_{4.5}O_2$.

The ground mixture was plasma sprayed on a surface of a substrate made of aluminum oxide in the air to form a ceramic superconductor film having a composition of $Y_1Ba_2Cu_3O_6$ and a thickness

of 100 μm on the substrate.

The produced ceramic superconductor composite material was heated in the air at 940°C for 6 hours and thereafter cooled to form a superconductor film having a composition of $Y_1Ba_2Cu_3O_7$ and a critical temperature of 85K and stable superconductive properties.

## Claims

1. A method for producing, on a substrate, a superconductor having a composition of the formula:

$$M^1_xM^2_yM^3_z \quad (I)$$

wherein $M^1$ is at least one element selected from the elements of the Ia, IIa and IIIa groups, $M^2$ is at least one element selected from the group consisting of elements of Ib, IIb and IIIb groups and $M^3$ is at least one element selected from the group consisting of oxygen, nitrogen, fluorine, carbon and sulfur, which comprises flame spraying a raw material selected from the group consisting of complex ceramics comprising the elements $M^1$, $M^2$ and $M^3$ and a mixture of the elements $M^1$, $M^2$ and $M^3$ or compounds each comprising at least one of the elements $M^1$, $M^2$ and $M^3$.

2. The method according to claim 1, wherein $M^1$ is at least two element selected from the elements of the Ia, IIa and IIIa groups.

3. The method according to claim 1, wherein the complex ceramics is a ceramic superconductor.

4. The method according to claim 1, wherein the flame spraying is carried out under reduced pressure.

5. The method according to claim 1, wherein the elements $M^1$ and $M^2$ or their compounds are flame sprayed, and the formed material is heated in an atmosphere containing the element $M^3$ to obtain a ceramic superconductor having the composition (I).

6. The method according to claim 1, wherein the substrate has a coefficient of linear expansion of not larger than $15 \times 10^{-6}/°C$.

7. The method according to claim 1, wherein a composite material of the substrate and the ceramic superconductor is heated at a temperature not lower than 500°C, preferably not lower than 800°C, more preferably not lower than 940°C and then gradually cooled.

8. The method according to claim 6, wherein the composite material of the substrate and the ceramic superconductor is heated at a temperature not lower than 500°C, preferably not lower than 800°C, more preferably not lower than 940°C and then gradually cooled.

9. The method according to claim 7, wherein the composite material is heated in an atmosphere containing the element $M^3$ in a concentration of not smaller than 10 atomic %.

10. The method according to claim 8, wherein the composite material is heated in an atmosphere containing the element $M^3$ in a concentration of not smaller than 10 atomic %.

11. The method according to claim 1, wherein the flame spraying is carried out in the presence of oxygen, and a composite material of the substrate and the ceramic superconductor is heated in an atmosphere containing no oxygen.

12. The method according to claim 11, wherein the composite material is heated at a temperature not lower than 500°C.

13. The method according to claim 11, wherein the atmosphere containing no oxygen is a reducing atmosphere.

14. The method according to claim 11, wherein the atmosphere containing no oxygen is an inert gas atmosphere.

15. The method according to claim 11, wherein the atmosphere containing no oxygen is an atmosphere of reduced pressure.

16. The method according to claim 1, wherein the flame spraying is carried out in the presence of oxygen, and the raw material contains the element $M^3$ in a content which is smaller than the content of the element $M^3$ in the formed ceramic superconductor.

0 286 135

**Fig. 1**

**Fig. 2**

**Fig. 3**